# EUROPEAN PATENT APPLICATION

(11) **EP 4 106 074 A1**
(43) Date of publication of application: **21.12.2022**
(21) Application number: 21753099.7
(22) Date of filing: 12.02.2021
(51) Int. Cl.: H01M 10/42, H01M 10/48, H02J 7/00, G01R 31/392

(54) **DEGRADATION DETERMINATION DEVICE FOR STORAGE BATTERY SYSTEM, DEGRADATION DETERMINATION METHOD FOR STORAGE BATTERY SYSTEM, STORAGE BATTERY SYSTEM, AND STORAGE BATTERY MONITORING DEVICE**

(30) Priority: 12.02.2020 JP 2020021240
(71) Applicant: FURUKAWA ELECTRIC CO., LTD., Chiyoda-ku Tokyo 100-8322 (JP); The Furukawa Battery Co., Ltd., Yokohama-shi, Kanagawa-ken 240-0006 (JP)
(72) Inventor: NAKAMURA, Hideto, Tokyo 100-8322 (JP); TANAKA, Akira, Tokyo 100-8322 (JP); ARAGAKI, Masanobu, Tokyo 100-8322 (JP); YOSHIDA, Hideaki, Nikko-shi, Tochigi 321-2336 (JP); TEZUKA, Wataru, Nikko-shi, Tochigi 321-2336 (JP); SATO, Akihiro, Yokohama-shi, Kanagawa 240-0006 (JP)
(74) Representative: SSM Sandmair
(86) International application number: PCT/JP2021/005191
(87) International publication number: WO 2021/162077

(57) **Abstract**

In a deterioration determination device for a storage battery system, a plurality of storage battery arrays, each of which is formed by connecting a plurality of storage batteries to each other in series, is connected to each other in parallel. The storage batteries are bipolar lead storage batteries. In the storage battery arrays connected to each other, the storage batteries positioned at one end portion of the storage battery arrays are connected to each other in parallel, and the storage batteries positioned in the middle part of the storage battery arrays are connected to each other in parallel. As a result, the storage battery system is divided into a plurality of storage battery array blocks. The deterioration determination device includes a current sensor that, at the time of stopping the charging or stopping the discharging of the storage batteries, measures the circulation current generated among the storage battery arrays in each of the storage battery array blocks; includes a measurement control unit that collects the value of the circulation current measured by the current sensor; and includes a storage battery state determining unit that, from the collected value of the circulation current, determines whether or not there is deterioration of the storage batteries in the storage battery array blocks.

## Description

### Field

The present invention is related to a deterioration determination device for a storage battery system, a deterioration determination method for a storage battery system, a storage battery system, and a storage battery monitoring device; and is particularly related to a deterioration determination device for a storage battery system, a deterioration determination method for a storage battery system, a storage battery system, and a storage battery monitoring device that enable determination about deterioration of a storage battery system by measuring the circulation current generated at the time of stopping the charging and stopping the discharging.

### Background

At the time of using storage batteries, in order to achieve the desired voltage or the desired capacity, there are times when a storage battery system in which storage batteries are connected in series to form a storage battery array, and such storage battery arrays are connected in parallel to configure an assembled storage battery. In a storage battery system, if malfunctioning such as internal short-circuit or internal liquid junction occurs in any storage battery, the storage battery array that includes the malfunctioning storage battery undergoes an increase or a decrease in the internal resistance as compared to the other storage battery arrays. That results in over-discharging or overcharging, thereby sometimes accelerating the deterioration. Particularly, when the storage batteries are bipolar lead storage batteries, due to the structure formed by laminated electrodes, the temperature in the central portion easily rises; and the temperature in each storage battery becomes different. Hence, the state of deterioration also differs in each storage battery, and there is a risk of acceleration in the deterioration as a result of the occurrence of internal short-circuit or internal liquid junction attributed to the temperature degradation or the progress in deterioration. Hence, in the case of using bipolar lead storage batteries in a storage battery system, it becomes necessary to determine whether or not there is deterioration of the storage batteries that constitute the storage battery system, and to replace the deteriorated storage batteries in advance before any malfunctioning occurs.

In that regard, a technology has been proposed in which the charging current (Ic) of each storage battery array is measured, and deterioration such as internal short-circuit or internal liquid junction of specific storage battery arrays is determined based on the relative comparison of the measured charging current (Ic) of each storage battery array or based on the difference between the charging current (Ic) in the initial stage of use and the charging current (Ic) after the use (Patent Literature 1) .

However, when there is temperature distribution in an assembled storage battery, sometimes temperature difference occurs in each storage battery array. In the storage batteries, the charging characteristics differ depending on the temperature state at the time of charging. A storage battery charged under high temperature tends to have enhanced charging characteristics as compared to a storage battery charged under low temperature. Thus, with reference to Patent Literature 1, when there is temperature distribution in an assembled storage battery, the charging current value (Icc) of a storage battery array that is charged under relatively high temperature becomes greater than the charging current value (Icc) of a storage battery array that is charged under relatively low temperature. Hence, at the time of determining the deterioration of a storage battery array, there is a possibility of erroneous determination.

Regarding the details of the abovementioned issues faced in a conventional deterioration determination device for a storage battery system, the explanation is given below with reference to the drawings. FIG. 8 is an overall configuration diagram of a conventional deterioration determination device for a storage battery system. FIG. 9 is an overall configuration diagram of the state in which, in the conventional deterioration determination device for a storage battery system, two storage battery arrays are installed in the same storage battery rack. FIG. 10 is a graph indicating the time variation in the charging current (Ic) as a result of charging of storage batteries when, in the conventional deterioration determination device for a storage battery system, two storage battery arrays are installed in the same storage battery rack.

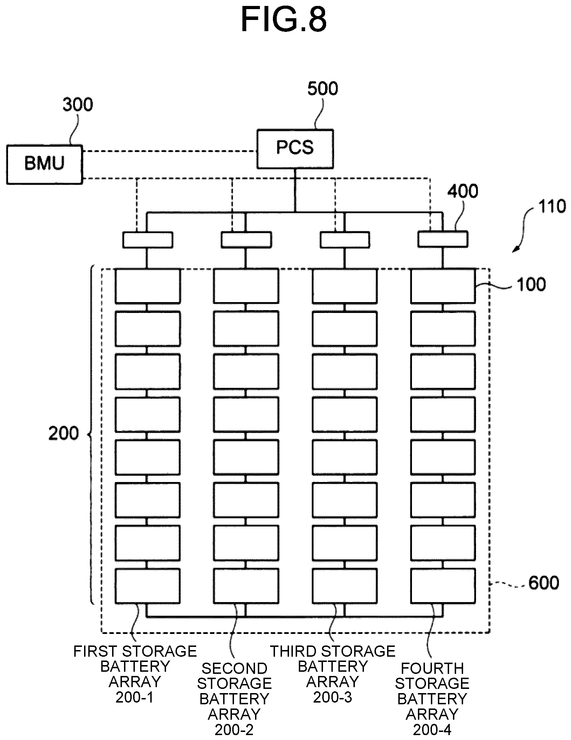

As illustrated in FIG. 8, in a conventional deterioration determination device 110 for a storage battery system, a plurality of (eight in FIG. 8) storage batteries 100 is connected in series to constitute a single storage battery array 200, and a plurality of such storage battery arrays 200 (in FIG. 8, four storage battery arrays 200, namely, a first storage battery array 200-1, a second storage battery array 200-2, a third storage battery array 200-3, and a fourth storage battery array 200-4) is connected in parallel to constitute an assembled storage battery 600. The assembled storage battery 600 is connected to an AC/DC transfer device (PCS: Power Conditioning System) 500. In between each storage battery array 200 and the AC/DC transfer device 500, a current sensor 400 is installed for measuring the charging current and the discharging current in the concerned storage battery array 200; and measurement information of the current sensors 400 is input to a storage battery monitoring device (BMU: Battery Management Unit) 300. When the AC/DC transfer device 500 starts the charging of the assembled storage battery 600, the storage battery monitoring device 300 refers to the value of the charging current (Ic) input from the current sensor 400 installed in each storage battery array 200, and obtains the degree of variability in the charging currents (Ic) among the storage battery arrays 200; as well as compares the charging current (Ic) of each storage battery array 200 at the initial stage of installation of the storage battery system with the charging current (Ic) of the storage battery array 200 after the use and, according to the difference, determines whether or not deterioration, such as internal short-circuit or internal liquid junction, that can lead to malfunctioning has occurred in the storage batteries 100 in each storage battery array 200. Thus, in the conventional deterioration determination device 110 for a storage battery system, at the time of charging the assembled storage battery 600, it is determined whether or not deterioration, such as internal short-circuit or internal liquid junction, that can lead to malfunctioning has occurred in the storage batteries 100.

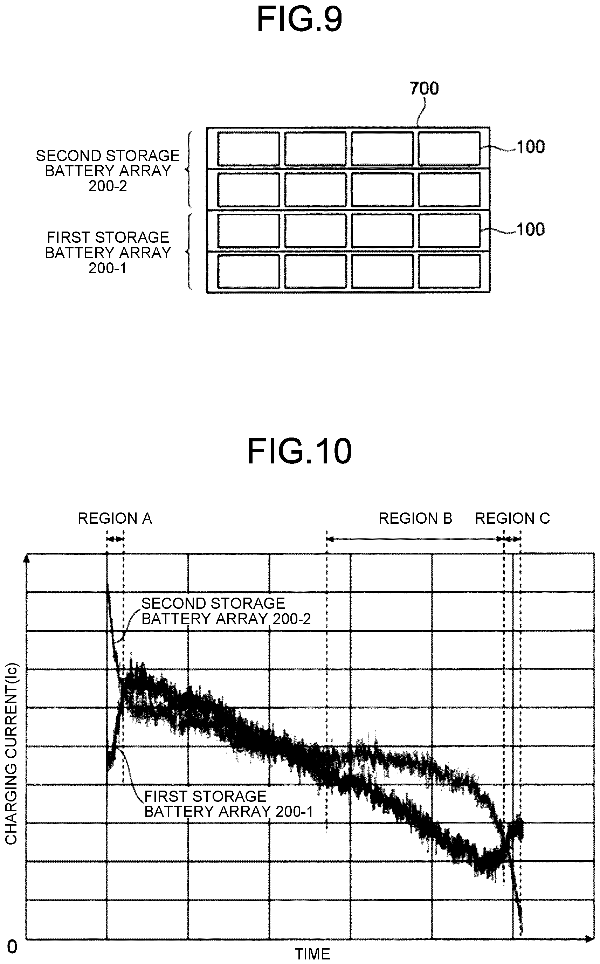

As illustrated in FIG. 9, for example, when the first storage battery array 200-1 and the second storage battery array 200-2 are installed in a single storage battery rack 700, with the first storage battery array 200-1 positioned at the lower level and the second storage battery array 200-2 positioned at the upper level; there occurs temperature distribution in the storage battery rack 700 mainly due to the charging of the assembled storage battery 600. That is, the second storage battery array 200-2, which is installed at the upper level of the storage battery rack 700, tends to have a higher temperature than the first storage battery array 200-1, which is installed at the lower level of the storage battery rack 700. Thus, at the time of charging the storage batteries 100, in the second storage battery array 200-2, the charging current tends to be greater than in the first storage battery array 200-1.

FIG. 10 is a graph indicating the time variation in the charging current (Ic) of the first storage battery array 200-1 and the charging current (Ic) of the second storage battery array 200-2 as a result of charging of the storage batteries 100, when the first storage battery array 200-1 and the second storage battery array 200-2 are disposed as illustrated in FIG. 9, that is, when the first storage battery array 200-1 and the second storage battery array 200-2 are installed in the same storage battery array 700 with the first storage battery array 200-1 positioned at the lower level and the second storage battery array 200-2 positioned at the upper level. Herein, during the charging of the storage batteries 100, the average temperature in the second storage battery array 200-2 was higher by about 2 °C than the average temperature in the first storage battery array 200-1.

As illustrated in FIG. 10, in a region "A" positioned immediately after the start of charging of the storage batteries 100 and in a region "B" positioned before the end of the charging of the storage batteries 100, the charging current (Ic) in the second storage battery array 200-2 is greater than the charging current (Ic) in the first storage battery array 200-1. On the other hand, in a region "C" positioned immediately before the end of charging of the storage batteries 100, the charging current (Ic) in the first storage battery array 200-1 is greater than the charging current (Ic) in the second storage battery array 200-2. In this way, in the state in which temperature distribution has occurred among the storage battery arrays 200 of the storage battery system constituting the assembled storage battery 600, if it is determined according to the charging current (Ic) about whether or not there is deterioration of the storage batteries 100 of the storage battery system, then there are times when, regardless of the fact that the storage batteries 100 of the storage battery system constituting the assembled storage battery 600 have not undergone any deterioration that could lead to malfunctioning such as internal short-circuit or internal liquid junction, it is erroneously determined that deterioration has occurred; and there are times when, regardless of the fact that the storage batteries 100 of the storage battery system constituting the assembled storage battery 600 have undergone some deterioration that could lead to malfunctioning such as internal short-circuit or internal liquid junction, it is erroneously determined that deterioration has not occurred.

Moreover, if there is a large number of storage batteries 100 connected in series in the storage battery array 200; in the first place, there is an increase in the internal resistance of the storage battery array 200. Hence, until there is any malfunctioning such as internal short-circuit or internal liquid junction in the storage batteries 100, it is difficult to determine that deterioration which could lead to such malfunctioning has occurred in the storage batteries 100.

### Citation List

### Patent Literature

Patent Literature 1: Japanese Patent Application Laid-open No. 2012-88097

### Summary

### Technical Problem

In view of the issues mentioned above, it is an objective of the present invention to provide a deterioration determination device for a storage battery system, a deterioration determination method for a storage battery system, a storage battery system, and a storage battery monitoring device, with an enhanced accuracy in the determination about deterioration of the storage battery system.

### Solution to Problem

In the present invention, each storage battery array, in which a plurality of storage batteries is connected, is divided into a plurality of storage battery array blocks. At the time of stopping the charging or stopping the discharging of the storage batteries constituting a storage battery system, the circulation current generated among the storage battery arrays in regard to each storage battery array block is measured, and the presence or absence of deterioration of the storage battery system is determined. The circulation current generated among the storage battery arrays gets generated due to the voltage difference attributed to the difference in the charging characteristics of each storage battery array.

The summary of the configuration of the present invention is as follows.
(1) A deterioration determination device for a storage battery system in which a plurality of storage battery arrays, each of which is formed by connecting a plurality of storage batteries to each other in series, is connected to each other in parallel, wherein the storage batteries are bipolar lead storage batteries, in the storage battery arrays connected to each other, the storage batteries positioned at end portion of the storage battery arrays are connected to each other in parallel, and the storage batteries positioned in middle part of the storage battery arrays are connected to each other in parallel, because of which the storage battery system is divided into a plurality of storage battery array blocks, the deterioration determination device including:
   a current sensor configured to, at a time of stopping charging or stopping discharging of the storage batteries, measure circulation current generated among the storage battery arrays in each of the storage battery array blocks;
   a measurement control unit configured to collect a value of the circulation current measured by the current sensor; and
   a storage battery state determining unit configured to, from the collected value of the circulation current, determine whether or not there is deterioration of the storage batteries in the storage battery array blocks.
(2) The deterioration determination device for the storage battery system according to (1), wherein one of the storage battery array blocks is connected to other of the storage battery array blocks in series by a single connection.
(3) The deterioration determination device for the storage battery system according to (1) or (2), wherein the current sensor is installed in plurality in each of the storage battery array blocks.
(4) The deterioration determination device for the storage battery system according to (3), wherein, in each of the storage battery array blocks, the current sensor is installed between each neighboring pair of the storage battery arrays.
(5) The deterioration determination device for the storage battery system according to (1) or (2), wherein the current sensor is installed in singularity in each of the storage battery array blocks.
(6) The deterioration determination device for the storage battery system according to any one of (1) to (5), wherein, between an AC/DC transfer device and the storage battery system, a switch is disposed for delinking the AC/DC transfer device and the storage battery system at time of stopping charging or stopping discharging of the storage batteries.
(7) A deterioration determination method for a storage battery system in which a plurality of storage battery arrays, each of which is formed by connecting a plurality of storage batteries to each other in series, is connected to each other in parallel, wherein the storage batteries are bipolar lead storage batteries, in the storage battery arrays connected to each other, the storage batteries positioned at end portion of the storage battery arrays are connected to each other in parallel, and the storage batteries positioned in middle part of the storage battery arrays are connected to each other in parallel, because of which the storage battery system is divided into a plurality of storage battery array blocks, the deterioration determination method including:
   a step of measuring, at a time of stopping charging or stopping discharging of the storage batteries, circulation current generated among the storage battery arrays in each of the storage battery array blocks,
   a step of collecting a value of the circulation current measured by the current sensor; and
   a step of determining, from the collected value of the circulation current, whether or not there is deterioration of the storage batteries in the storage battery array blocks.
(8) A deterioration determination device for a storage battery system including a plurality of assembled storage batteries each of which is formed by connecting, in series, a plurality of storage battery blocks in which a plurality of storage battery arrays, each of which is formed by connecting a plurality of storage batteries to each other in series, are connected to each other in parallel, wherein the storage batteries are bipolar lead storage batteries, the deterioration determination device including:
   a measurement control unit configured to collect values of circulation currents measured by current sensors which are disposed corresponding to the assembled storage batteries, are connected to each other in parallel, and measure, at time of stopping charging or stopping discharging of the storage batteries, the circulation currents generated among the assembled storage batteries; and
   a storage battery state determining unit configured to, from the collected values of the circulation currents, determine about the deterioration of the storage batteries.
(9) The deterioration determination device for the storage battery system according to (8), wherein, when sum of the circulation currents measured by the current sensors is equal to or smaller than a predetermined first threshold value and when absolute value of each of the circulation currents measured by the current sensors is equal to or greater than a predetermined second threshold value, the storage battery state determining unit determines that there is deterioration of the storage batteries.
(10) A storage battery monitoring device for monitoring a storage battery system including a plurality of assembled storage batteries each of which is formed by connecting, in series, a plurality of storage battery blocks in which a plurality of storage battery arrays, each of which is formed by connecting a plurality of storage batteries to each other in series, are connected to each other in parallel, and in which the assembled storage batteries are connected to each other in parallel, wherein the storage batteries are bipolar lead storage batteries, the storage battery monitoring device including:
   a measurement control unit configured to collect values of circulation currents measured by current sensors which are disposed corresponding to the assembled storage batteries, are connected to each other in parallel, and measure, at time of stopping charging or stopping discharging of the storage battery, the circulation currents generated among the assembled storage batteries; and
   a storage battery state determining unit configured to, from the collected values of the circulation currents, determine about the deterioration of the storage batteries.
(11) The storage battery monitoring device according to (10), wherein, when sum of the circulation currents measured by the current sensors is equal to or smaller than a predetermined first threshold value and when absolute value of each of the circulation currents measured by the current sensors is equal to or greater than a predetermined second threshold value, the storage battery state determining unit determines that there is deterioration of the storage batteries.
(12) A storage battery system including:
   the deterioration determination device for a storage battery system according to (8) or (9) or the storage battery monitoring device according to (10) or (11); and
   a storage battery array in which a plurality of storage batteries is connected to each other in series, wherein
   the storage batteries are bipolar lead storage batteries,
   the assembled storage batteries are connected to each other in parallel, and
   in corresponding manner to the assembled storage batteries, current sensors are disposed that measure, at time of stopping charging or stopping discharging of the storage batteries, circulation currents generated among the assembled storage batteries, and are connected to each other in parallel.
(13) A deterioration determination method for a storage battery system including a plurality of assembled storage batteries each of which is formed by connecting, in series, a plurality of storage battery blocks in which a plurality of storage battery arrays, each of which is formed by connecting a plurality of storage batteries to each other in series, are connected to each other in parallel, wherein the storage batteries are bipolar lead storage batteries, the deterioration determination method including:
   a step of collecting values of circulation currents measured by current sensors which are disposed corresponding to the assembled storage batteries, are connected to each other in parallel, and measure, at time of stopping charging or stopping discharging of the storage batteries, the circulation currents generated among the assembled storage batteries; and
   a step of determining, from the collected values of the circulation currents, about deterioration of the storage batteries.

### Advantageous Effects of Invention

According to an aspect of the present invention, the circulation current that is generated due to the voltage difference among the storage battery arrays is measured at the time of stopping the charging or stopping the discharging of the storage batteries. As a result, the storage battery system can be prevented from getting affected by the temperature distribution. That enables achieving enhancement in the accuracy of deterioration determination of the storage battery system. Moreover, according to an aspect of the present invention, since each storage battery array, in which a plurality of storage batteries is connected in series, is divided into a plurality of storage battery array blocks; it becomes possible to prevent an increase in the internal resistance of the storage battery array. That results in an improvement in the flow of the circulation current, thereby enabling achieving enhancement in the measurement accuracy of the circulation current, as well as achieving enhancement in the accuracy of determining deterioration of the storage batteries before any malfunctioning, such as internal short-circuit or internal liquid junction, occurs in the storage batteries.

According to an aspect of the present invention, a storage battery array block is connected in series to another storage battery array block using a single connection. Hence, the circulation current generated in each storage battery array block can be measured with accuracy, thereby enabling achieving enhancement in the accuracy of deterioration determination of the storage battery system.

According to an aspect of the present invention, in a storage battery array block, a current sensor is installed between each pair of neighboring storage battery arrays. As a result, the determination about deterioration can be accurately performed for each storage battery array in the storage battery array block.

According to an aspect of the present invention, a single current sensor is installed in each storage battery array block. Hence, the determination about deterioration of the storage battery system can be individually performed for each storage battery array block. Hence, at the time of replacing the storage batteries of each storage battery array block, the accuracy of deterioration determination of the storage battery system is enhanced using a simple structure.

According to an aspect of the present invention, in between an AC/DC transfer device and the storage battery system, a switch is included for delinking the AC/DC transfer device and the storage battery system at the time of stopping the charging or stopping the discharging of the storage batteries. Hence, the circulation current can be measured while preventing the impact caused by the AC/DC transfer device. That enables achieving further enhancement in the accuracy of deterioration determination of the storage battery system.

### Brief Description of Drawings

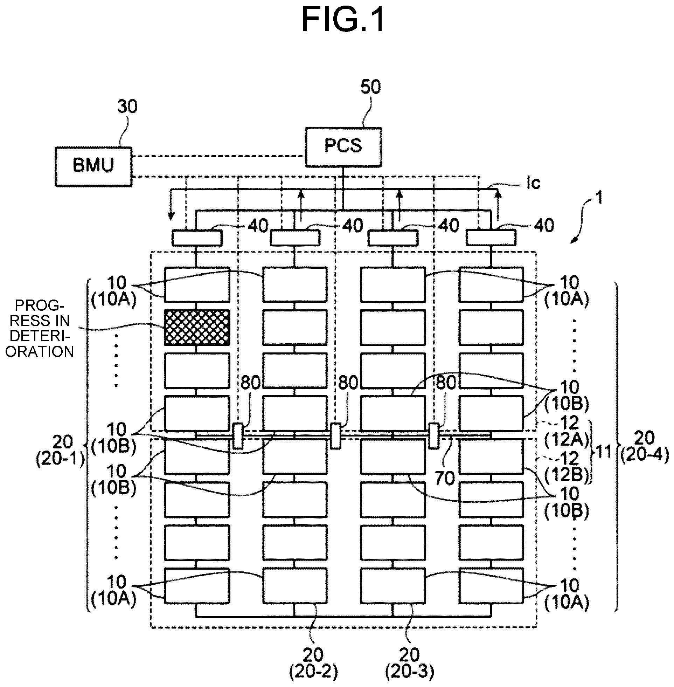

FIG. 1 is an overall configuration diagram of a deterioration determination device for a storage battery system according to a first embodiment of the present invention.

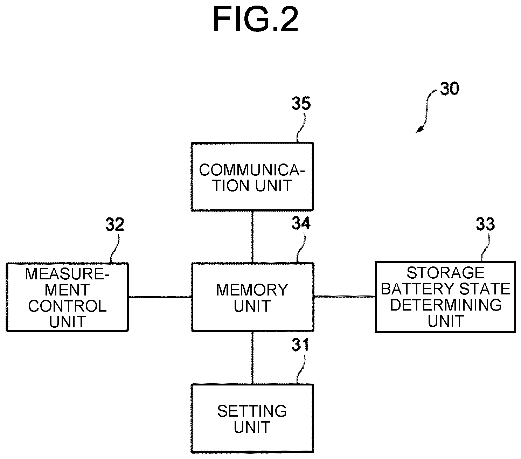

FIG. 2 is a configuration diagram of the functional blocks of a storage battery monitoring device that is included in the deterioration determination device for a storage battery system according to the first embodiment of the present invention.

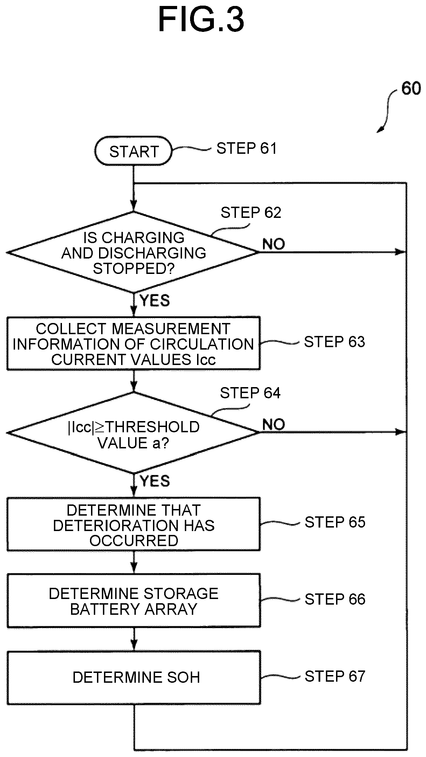

FIG. 3 is a flowchart for explaining the deterioration determination performed in the deterioration determination device for a storage battery system according to the first embodiment of the present invention.

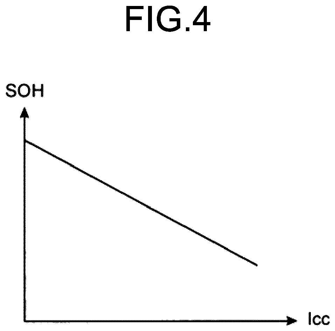

FIG. 4 is a graph indicating the relationship between the circulation current generated among storage battery arrays and the degree of deterioration of a storage battery array block.

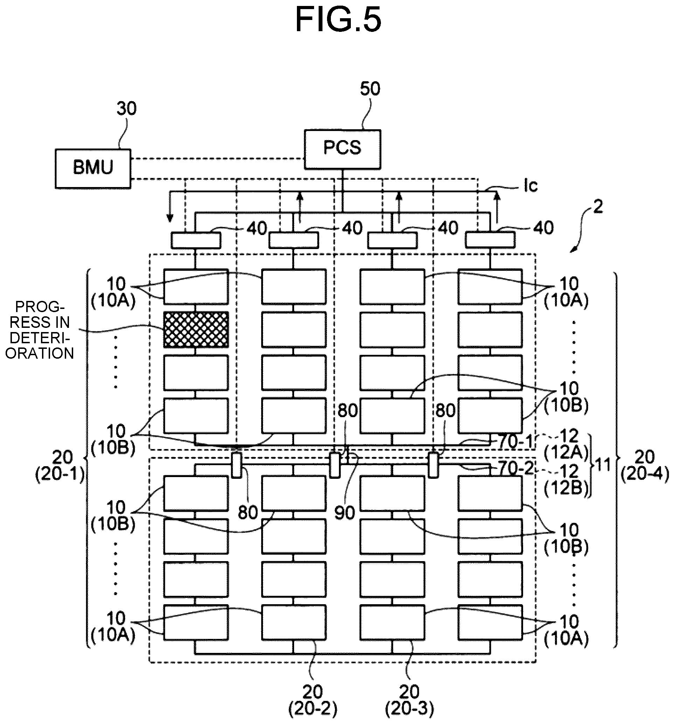

FIG. 5 is an overall configuration diagram of a deterioration determination device for a storage battery system according to a second embodiment of the present invention.

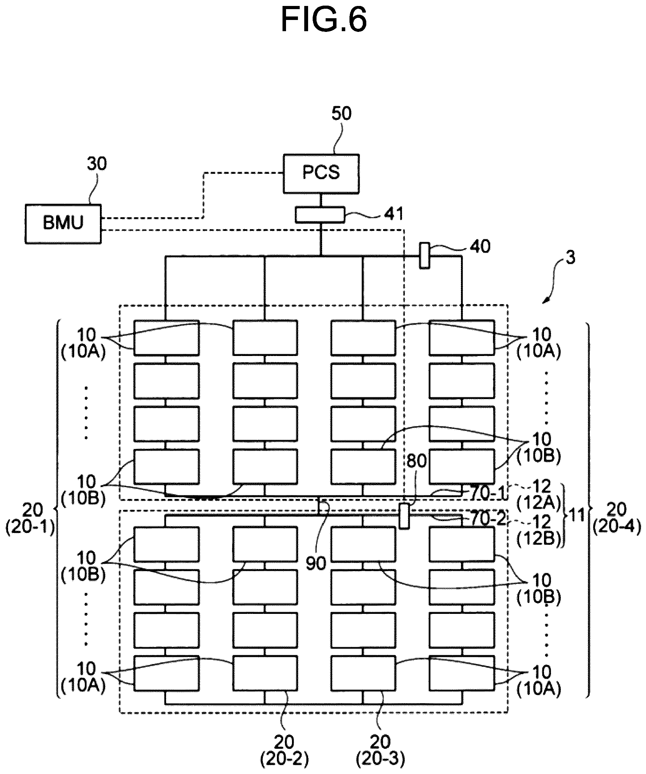

FIG. 6 is an overall configuration diagram of a deterioration determination device for a storage battery system according to a third embodiment of the present invention.

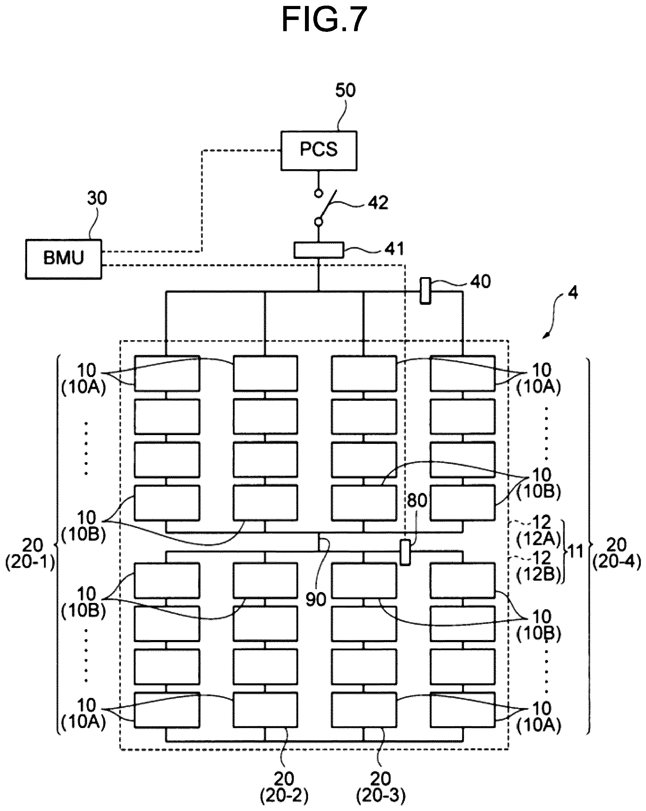

FIG. 7 is an overall configuration diagram of a deterioration determination device for a storage battery system according to a fourth embodiment of the present invention.
FIG. 8 is an overall configuration diagram of a conventional deterioration determination device for a storage battery system.
FIG. 9 is an overall configuration diagram of the state in which, in the conventional deterioration determination device for a storage battery system, two storage battery arrays are installed in the same storage battery rack.
FIG. 10 is a graph indicating the time variation in the charging current (Ic) as a result of charging of storage batteries when, in the conventional deterioration determination device for a storage battery system, two storage battery arrays are installed in the same storage battery rack.

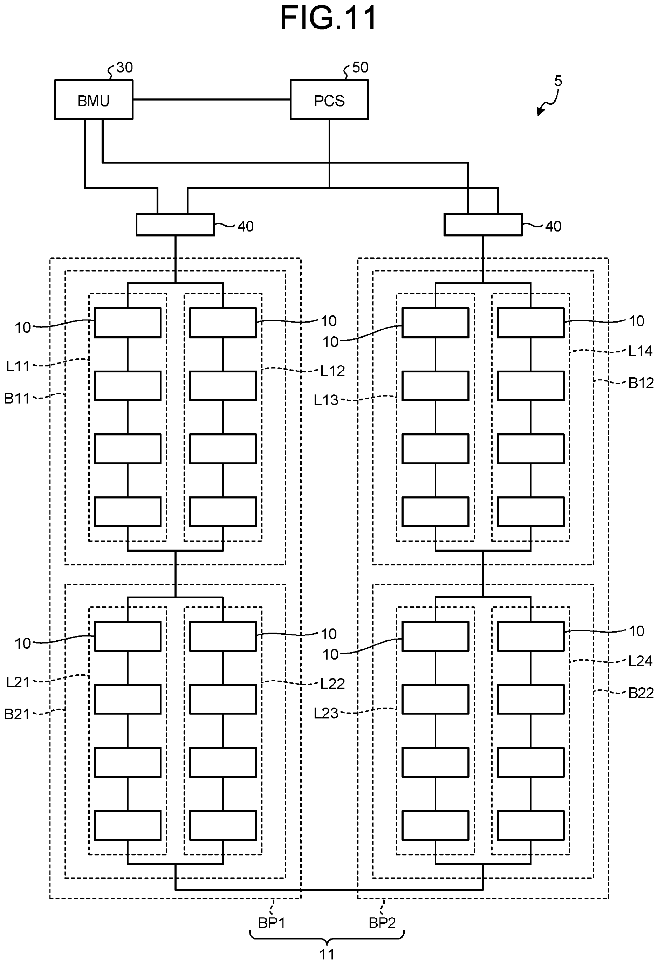

FIG. 11 is an overall configuration diagram of a deterioration determination device for a storage battery system according to a fifth embodiment of the present invention.

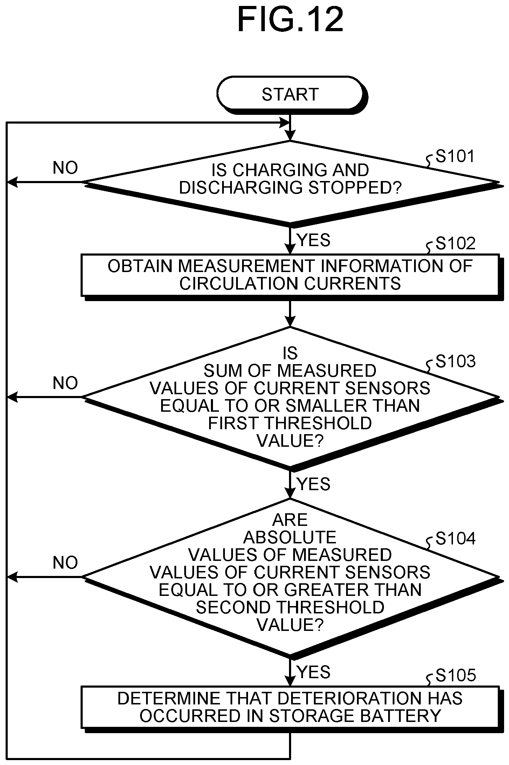

FIG. 12 is a flowchart for explaining the flow of operations performed for determining about the deterioration of the storage batteries according to the fifth embodiment.

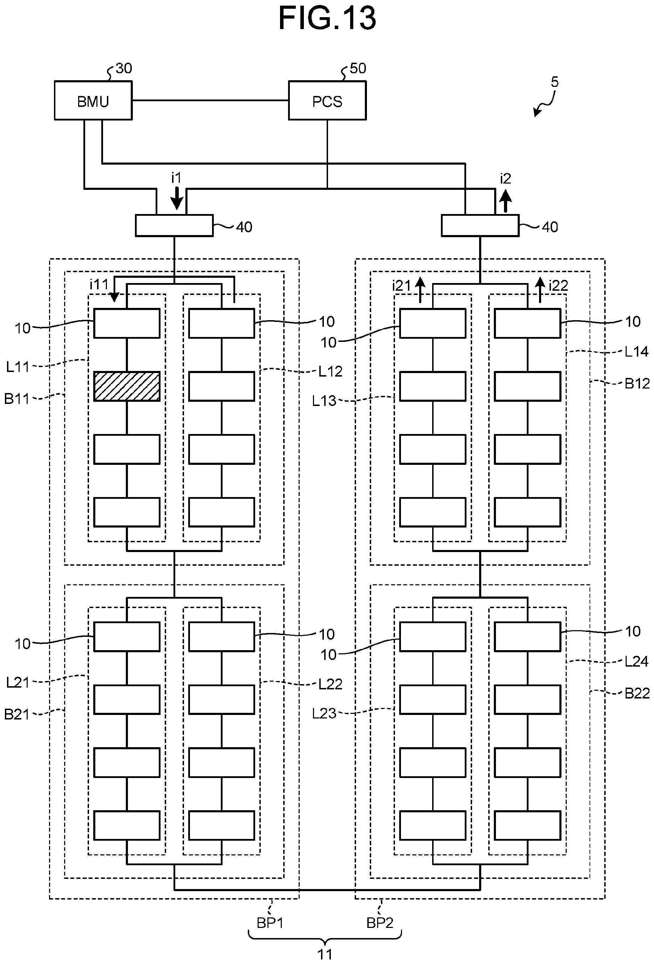

FIG. 13 is an overall configuration diagram of the deterioration determination device for a storage battery system according to the fifth embodiment of the present invention.

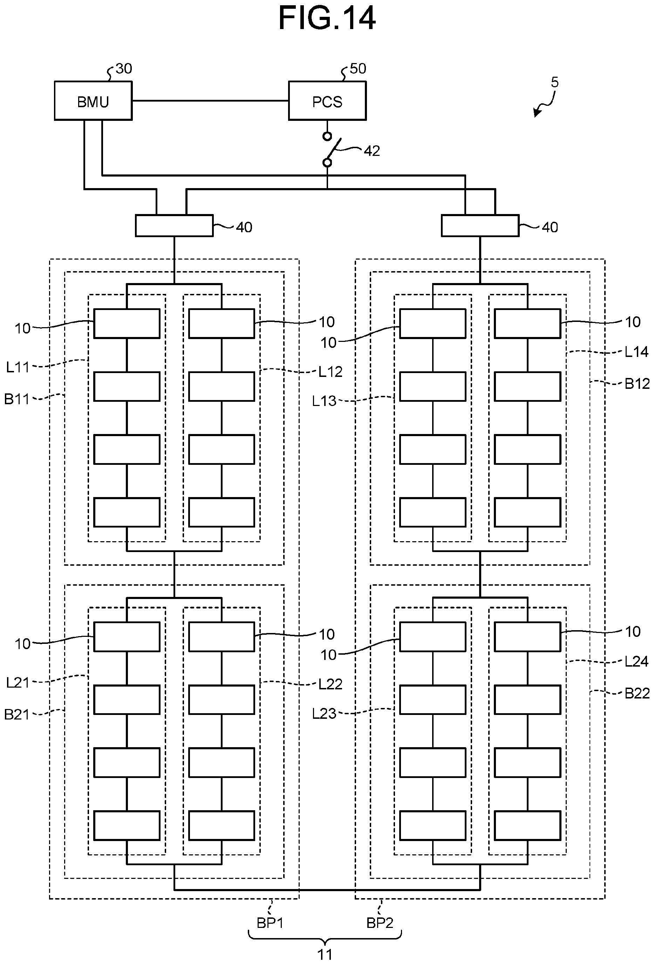

FIG. 14 is an overall configuration diagram of a modification example of the fifth embodiment according to the present invention.

### Description of Embodiments

### <First embodiment>

Given below is the explanation of a deterioration determination device 1 for a storage battery system according to a first embodiment of the present invention. FIG. 1 is an overall configuration diagram of the deterioration determination device for a storage battery system according to the first embodiment of the present invention. FIG. 2 is a configuration diagram of the functional blocks of a storage battery monitoring device that is included in the deterioration determination device for a storage battery system according to the first embodiment of the present invention. FIG. 3 is a flowchart for explaining the deterioration determination performed in the deterioration determination device for a storage battery system according to the first embodiment of the present invention. FIG. 4 is a graph indicating the relationship between the circulation current generated among storage battery arrays and the degree of deterioration of a storage battery array block.

As illustrated in FIG. 1, the deterioration determination device 1 for a storage battery system according to the first embodiment is a device for determining about deterioration of a storage battery system 11 that is an assembled storage battery in which a plurality of storage battery arrays 20 is connected in parallel, with each storage battery array 20 including a plurality of storage batteries 10 connected in series. In FIG. 1, for the purpose of illustration, a single storage battery array 20 includes eight storage batteries 10 connected in series. Moreover, in the deterioration determination device 1 for a storage battery system, for the purpose of illustration, four storage battery arrays 20, namely, a first storage battery array 20-1, a second storage battery array 20-2, a third storage battery array 20-3, and a fourth storage battery array 20-4 are connected in parallel in that order.

The storage battery system 11 is connected to an AC/DC transfer device (PCS) 50. Moreover, via the AC/DC transfer device (PCS) 50, the storage battery system 11 is connected to an external electrical power system (not illustrated).

In the deterioration determination device 1 for a storage battery system, in a plurality of storage battery arrays 20, the storage batteries 10 positioned at one end portion of the storage battery arrays 20 (i.e., storage batteries 10A) are connected to each other in parallel, and the storage batteries 10 positioned in the middle part of the storage battery arrays 20 are connected to each other in parallel. As a result, the storage battery system 11 gets divided into a plurality of storage battery array blocks 12. In FIG. 2, for the purpose of illustration, in a plurality of storage battery arrays 20, the storage batteries 10 (10B) at the fourth position and the fifth position from the AC/DC transfer device (PCS) 50 are connected to each other in parallel. Moreover, the storage batteries 10 (10B) in the middle part of the storage battery arrays 20 are connected to each other in parallel by a conduction bar 70 that is a connection cable. In the deterioration determination device 1 for a storage battery system, from among a plurality of storage batteries 10 (10B) positioned in the middle part of the storage battery arrays 20, a plurality of storage battery arrays 20 are connected to each other in parallel at a predetermined row of the storage batteries 10 (10B). Thus, the storage battery system 11 gets divided into storage battery array blocks 12A and 12B across the single conduction bar 70.

The storage battery arrays 20 positioned in the storage battery array block 12A, that is, the first storage battery array 20-1, the second storage battery array 20-2, the third storage battery array 20-3, and the fourth storage battery array 20-4 positioned in the storage battery array block 12A are connected by the conduction bar 70 to the storage battery arrays 20 positioned in the storage battery array block 12B, that is, the first storage battery array 20-1, the second storage battery array 20-2, the third storage battery array 20-3, and the fourth storage battery array 20-4 positioned in the storage battery array block 12B. That is, the storage battery array blocks 12A and 12B share the same conduction bar 70.

The deterioration determination device 1 for a storage battery system includes current sensors 40 and 80, which are the sensors for measuring the current value and the direction of flow of the current. The current sensors 40 are connected in between the storage battery arrays 20 and the AC/DC transfer device (PCS) 50. The current sensors 40 are connected to the storage batteries 10 (10A) that are positioned at the end portion of the storage battery arrays 20 on the side of the AC/DC transfer device (PCS) 50. Thus, the single current sensors 40 are installed between the first storage battery array 20-1 and the second storage battery array 20-2, between the second storage battery array 20-2 and the third storage battery array 20-3, and between the third storage battery array 20-3 and the fourth storage battery array 20-4. Accordingly, in the deterioration determination device 1 for a storage battery system, a plurality of (four in FIG. 1) current sensors 40 is installed in the storage battery array block 12A.

As illustrated in FIG. 1, for example, when deterioration is in progress in any storage battery 10 in the first storage battery array 20-1 positioned in the storage battery array block 12A, there occurs a drop in the voltage of the first storage battery array 20-1 at the time of stopping the charging and stopping the discharging of the storage batteries 10, as compared to the voltage of the second storage battery array 20-2, the third storage battery array 20-3, and the fourth storage battery array 20-4 positioned in the storage battery array block 12A. As a result, a circulation current representing the charging current Ic (hereinafter, the circulation current too is sometimes referred to using "Ic") gets generated from the second storage battery array 20-2, the third storage battery array 20-3, and the fourth storage battery array 20-4 to the first storage battery array 20-1. That is, at the time of stopping the charging and stopping the discharging of the storage batteries 10, the circulation current Ic is generated from the storage battery arrays 20 not including any deteriorating storage battery 10 to the storage battery arrays 20 including the deteriorating storage battery 10. At the time of stopping the charging or stopping the discharging of the storage batteries 10, the current sensors 40 measure the circuit current Ic generated among the first storage battery array 20-1, the second storage battery array 20-2, the third storage battery array 20-3, and the fourth storage battery array 20-4 positioned in the storage battery array block 12A; and measure the direction of the circulation current Ic.

The current sensors 80 are installed in the conduction bar 70. More particularly, a single current sensor 80 is installed between the first storage battery array 20-1 and the second storage battery array 20-2 positioned in the storage battery array block 12B, between the second storage battery array 20-2 and the third storage battery array 20-3 positioned in the storage battery array block 12B, and between the third storage battery array 20-3 and the fourth storage battery array 20-4 positioned in the storage battery array block 12B. Accordingly, a plurality of (three in FIG. 1) current sensors 80 is installed in the storage battery array block 12B.

For example, when deterioration is in progress in any storage battery 10 in the first storage battery array 20-1 positioned in the storage battery array block 12B, there occurs a drop in the voltage of the first storage battery array 20-1 at the time of stopping the charging and stopping the discharging of the storage batteries 10, as compared to the voltage of the second storage battery array 20-2, the third storage battery array 20-3, and the fourth storage battery array 20-4 positioned in the storage battery array block 12B. As a result, a circulation current (not illustrated) gets generated from the second storage battery array 20-2, the third storage battery array 20-3, and the fourth storage battery array 20-4 to the first storage battery array 20-1. At the time of stopping the charging or stopping the discharging of the storage batteries 10, the current sensors 80 measure the circuit current Ic generated among the first storage battery array 20-1, the second storage battery array 20-2, the third storage battery array 20-3, and the fourth storage battery array 20-4 positioned in the storage battery array block 12B; and measure the direction of the circulation current.

Meanwhile, as illustrated in FIG. 1, a storage battery monitoring device (BMU: Battery Management Unit) 30 is connected to the current sensors 40 and 80. The measurement information of the circulation current as measured by the current sensors 40 and 80 is input to the storage battery monitoring device 30.

The storage battery monitoring device 30 is also connected to the AC/DC transfer device 50. At the timing of stopping the charging of the storage battery system 11 from the AC/DC transfer device 50 or at the timing of stopping the discharging from the storage battery system 11 to an external electrical power system, the storage battery monitoring device 30 refers to the charging current values (Icc) received from the current sensors 40 and 80 and refers to the information about the direction of the charging current (Ic), and analyzes the comparison of the degrees of variability and the charging current values (Icc) of the charging current Ic among the first storage battery array 20-1, the second storage battery array 20-2, the third storage battery array 20-3, and the fourth storage battery array 20-4. Then, based on the analysis result, it is determined whether or not deterioration that could lead to malfunctioning such as internal short-circuit or internal liquid junction has occurred in the storage batteries 10 of the first storage battery array 20-1, the storage batteries 10 of the second storage battery array 20-2, the storage batteries 10 of the third storage battery array 20-3, and the storage batteries 10 of the fourth storage battery array 20-4.

As illustrated in FIG. 2, the storage battery monitoring device 30 is configured with the following: a setting unit 31 that sets deterioration determination conditions for the storage batteries 10; a measurement control unit 32 that collects, from the current sensors 40 and 80, measurement information about the circulation current; a storage battery state determining unit 33 that determines the state of the storage batteries 10 based on the measurement information collected by the measurement control unit 32; a memory unit 34 that is used to store the measurement information, the setting information, and the determination information; and a communication unit 35 that displays the determination information in an upper-level system or a screen.

The storage battery state determining unit 33 determines, based on the measurement information of the circulation current (Ic) as collected from the current sensors 40, whether or not there is deterioration of the storage batteries 10 of the first storage battery array 20-1, the storage batteries 10 of the second storage battery array 20-2, the storage batteries 10 of the third storage battery array 20-3, and the storage batteries 10 of the fourth storage battery array 20-4 positioned in the storage battery array block 12A. Moreover, based on the measurement information of the circulation current as collected from the current sensors 80, the storage battery state determining unit 33 determines whether or not there is deterioration of the storage batteries 10 of the first storage battery array 20-1, the storage batteries 10 of the second storage battery array 20-2, the storage batteries 10 of the third storage battery array 20-3, and the storage batteries 10 of the fourth storage battery array 20-4 positioned in the storage battery array block 12B.

Explained below with reference to a flowchart 60 in FIG. 3 are the operations of the deterioration determination device 1 for a storage battery system, which represent a working example of the deterioration determination method for a storage battery system according to the present invention. When the storage battery system 11 is operated by repeatedly performing, over a predetermined period of time, charging of the storage battery system 11 from an external electrical power system and discharging from the storage battery system 11 to the load; at the timing for determining the presence or absence of deterioration of the storage battery system 11 as set by the setting unit 31 of the storage battery monitoring device (BMU) 30, a deterioration determination process for the storage battery system 11 is started (Step 61). Then, the storage battery monitoring device 30 refers to the information received from the current sensors 40 or the AC/DC transfer device (PCS) 50, and determines whether or not the charging and the discharging of the storage battery system 11 has been stopped (Step 62). If the storage battery monitoring device 30 determines that the charging and the discharging of the storage battery system 11 has been stopped, the measurement control unit 32 of the storage battery monitoring device 30 measures the circulation current values (Icc) received from the current sensors 40 and 80 and measures the direction of the circulation current (Ic), and collects measurement information (Step 63).

Then, the storage battery state determining unit 33 determines whether or not the circulation current values (Icc) are equal to or greater than a threshold value "a" (Step 64). The threshold value "a" of the circulation current value (Icc) is set in advance by the setting unit 31.

If the circulation current values (Icc) are determined to be equal to or greater than the threshold value "a", then the storage battery state determining unit 33 determines that deterioration has occurred in some of the storage batteries 10 of the storage battery system 11 (Step 65). Moreover, as may be necessary, the storage battery monitoring device 30 displays about the occurrence of deterioration of the upper-level system or a control screen representing the communication unit 35 of the storage battery monitoring device (BMU) 30. Then, based on the measurement information of the circulation current (Ic) as received from the current sensors 40 and 80, the storage battery state determining unit 33 determines the storage battery array block 12 and the storage battery array 20 in which the deteriorating storage battery 10 is present (Step 66). Subsequently, the storage battery state determining unit 33 determines, from the circulation current values Icc, the degree of deterioration (SOH: State Of Health) of the storage battery array 20 in which the deteriorating storage battery 10 is present (Step 67).

As illustrated in FIG. 4, as far as the method for identifying the degree of deterioration (SOH) of the storage battery array 20 is concerned, for example, a method is used in which the calculation is performed using a linear function of the circulation current values (Icc) and the degree of deterioration (SOH). With reference to FIG. 4, it is implied that, smaller the SOH, the greater is the degree of deterioration; and that, greater the SOH, the smaller is the degree of deterioration. Meanwhile, as may be necessary, at the time of measuring the circulation current Ic, the temperature of each storage battery array block 12 can be measured, and the degree of deterioration (SOH) can be corrected according to the temperature distribution.

At Step 62, if it is determined that the charging and the discharging of the storage battery system 11 has not been stopped, then the storage battery monitoring device 30 again determines whether or not the charging and the discharging of the storage battery system 11 has been stopped (Step 62). Moreover, at Step S64, if the circulation current values (Icc) are determined to be smaller than the threshold value "a", then the system control returns to Step 62 and the storage battery monitoring device 30 determines whether or not the charging and the discharging of the storage battery system 11 has been stopped.

As far as the storage batteries 10 are concerned, for example, it is possible to use bipolar lead storage batteries. In a bipolar lead storage battery, cell members having an electrolyzer are alternately laminated with resin substrates in a plurality of layers in between the positive terminal and the negative terminal. Moreover, in between the opposing substrates, a resin frame is disposed for enclosing the cells; and the cell members are electrically connected to each other in series. The positive terminal includes a positive-terminal lead layer made of lead or a lead alloy, and includes a positive-terminal active substance layer that is formed on the positive-terminal lead layer and that includes an active substance. The negative terminal includes a negative-terminal lead layer made of lead or a lead alloy, and includes a negative-terminal active substance layer that is formed on the negative-terminal lead layer and that includes an active substance. The electrolyzer present in between the positive terminal and the negative terminal is, for example, a fiberglass mat impregnated in an electrolyte such as sulfuric acid. The resin substrate is made of thermoplastic resin resistant to sulfuric acid (for example, made of polyethylene, polypropylene, polyvinyl chloride, polymethylmethacrylate (acrylic resin), acrylonitrile butadiene styrene (ABS), polyamide (nylon), or polycarbonate); and is a frame plate formed in the shape of a quadrangular plate. Meanwhile, the current sensors 40 and 80 measure the charging current and the discharging current flowing to the storage battery arrays 20, and determine the charging state (SOC: State Of Health) of the storage batteries 10. Hence, it is desirable to use high-accuracy current sensors having excellent temperature characteristics and only a small measurement error.

In this way, in the deterioration determination device 1 for a storage battery system, the circulation current Ic that is generated due to the voltage difference among the storage battery arrays 20 is measured at the time of stopping the charging or stopping the discharging of the storage batteries 10. Hence, it becomes possible to prevent the storage battery system 11 from being affected by the temperature distribution, thereby enabling achieving enhancement in the accuracy of deterioration determination in the storage battery system 11. Moreover, in the deterioration determination device 1 for a storage battery system, since the circulation current Ic is measured at the time of stopping the charging or stopping the discharging of the storage batteries 10, the actual measurement of the current values of the circulation current Ic becomes easier and more sophisticated, thereby enabling achieving enhancement in the accuracy of deterioration determination in the storage battery system 11. Furthermore, in the deterioration determination device 1 for a storage battery system, the storage battery arrays 20, each including a plurality of storage batteries 10 connected in series, are divided into a plurality of storage battery array blocks 12. Hence, the internal resistance of the storage battery arrays 20 can be prevented from increasing, thereby allowing the circulation current Ic to flow freely. That enables achieving enhancement in the measurement accuracy of the circulation current Ic, and achieving enhancement in the accuracy of determination of deterioration of the storage batteries 10 before any malfunctioning, such as internal short-circuit or internal liquid junction, occurs in the storage batteries 10.

Moreover, in the deterioration determination device 1 for a storage battery system, the current sensors 40 and 80 are installed between the pairs of neighboring storage battery arrays 20 in the storage battery array blocks 12. Hence, for each storage battery array 20 in the storage battery array blocks 12, the deterioration determination can be performed with high accuracy.

### <Second embodiment>

Given below is the explanation of a deterioration determination device for a storage battery system according to a second embodiment of the present invention. In the deterioration determination device for a storage battery system according to the second embodiment, the main constituent elements are same as the deterioration determination device for a storage battery system according to the first embodiment. Hence, the identical constituent elements to the first embodiment are referred to by the same reference numerals. FIG. 5 is an overall configuration diagram of the deterioration determination device for a storage battery system according to the second embodiment of the present invention.

Regarding the deterioration determination device 1 for a storage battery system, the storage battery system 11 is divided into two storage battery array blocks 12A and 12B by a single conduction bar 70. Instead, as illustrated in FIG. 5, in a deterioration determination device 2 for a storage battery system, the first storage battery array 20-1, the second storage battery array 20-2, the third storage battery array 20-3, and the fourth storage battery array 20-4 positioned in the storage battery array block 12A are connected to each other in parallel by a first conduction bar 70-1; and the first storage battery array 20-1, the second storage battery array 20-2, the third storage battery array 20-3, and the fourth storage battery array 20-4 positioned in the storage battery array block 12B are connected to each other in parallel by a second conduction bar 70-2 that is different than the first conduction bar 70-1. Thus, regarding the deterioration determination device 2 for a storage battery system, the storage battery system 11 is divided into two storage battery array blocks 12A and 12B by different conduction bars 70.

The first conduction bar 70-1 and the second conduction bar 70-2 are connected to each other by a single storage-battery-array-block connection bar 90. That is, the first conduction bar 70-1 and the second conduction bar 70-2 are connected in series by a single connection (the storage-battery-array-block connection bar 90).

In the deterioration determination device 2 for a storage battery system; the current sensors 40, which measure the circulation current Ic generated among the storage battery arrays 20 positioned in the storage battery array block 12A, are connected to the storage batteries 10 (10A) positioned at the end portion of the respective storage battery arrays 20 on the side of the AC/DC transfer device (PCS) 50. Regarding the current sensors 80 that measure the circulation current Ic generated among the storage battery arrays 20 positioned in the storage battery array block 12B, a single current sensor 80 is installed between the first storage battery array 20-1 and the second storage battery array 20-2, between the second storage battery array 20-2 and the third storage battery array 20-3, and between the third storage battery array 20-3 and the fourth storage battery array 20-4. Herein, the current sensors 80 are installed in the second conduction bar 70-2.

In the deterioration determination device 2 for a storage battery system, since the storage battery array blocks 12A and 12B are connected to each other in series by a single connection, the circulation current Ic generated in each storage battery array block 12 can be accurately measured in that storage battery array block 12. That enables achieving further enhancement in the accuracy of deterioration determination of the storage battery system 11. That is, in the deterioration determination device 2 for a storage battery system, for example, if there is deterioration of any storage battery 10 positioned in the storage battery array block 12A and if there is no deterioration of the storage batteries 10 positioned in the storage battery array block 12B; the circulation current Ic flows more freely only in the storage battery array block 12A, and the circulation current Ic attributed to the storage battery array block 12A does not flow freely in the storage battery array block 12B.

### <Third embodiment>

Given below is the explanation of a deterioration determination device for a storage battery system according to a third embodiment of the present invention. In the deterioration determination device for a storage battery system according to the third embodiment, the main constituent elements are same as the deterioration determination device for a storage battery system according to the first and second embodiments. Hence, the identical constituent elements to the first and second embodiments are referred to by the same reference numerals. FIG. 6 is an overall configuration diagram of the deterioration determination device for a storage battery system according to the third embodiment of the present invention.

In the deterioration determination device 2 for a storage battery system according to the second embodiment; the current sensors 40, which measure the circulation current Ic generated among the storage battery arrays 20 positioned in the storage battery array block 12A, are connected to the respective storage battery arrays 20. Regarding the current sensors 80 that measure the circulation current Ic generated among the storage battery arrays 20 positioned in the storage battery array block 12B, a single current sensor 80 is installed between the first storage battery array 20-1 and the second storage battery array 20-2, between the second storage battery array 20-2 and the third storage battery array 20-3, and between the third storage battery array 20-3 and the fourth storage battery array 20-4. In contrast, as illustrated in FIG. 6, in a deterioration determination device 3 for a storage battery system, only a single current sensor is installed in each storage battery array block 12.

As illustrated in FIG. 6, a single current sensor 40 is installed between a plurality of storage battery arrays 20 connected to each other in parallel in the storage battery array block 12A; and a single current sensor 80 is installed between a plurality of storage battery arrays 20 connected to each other in parallel in the storage battery array block 12B. Thus, in the deterioration determination device 3 for a storage battery system, a single current sensor 40 and a single current sensor 80 measure the circulation current among a plurality of storage battery arrays 20. Meanwhile, in the deterioration determination device 3 for a storage battery system, a single current sensor 40 as well as a single current sensor 80 is installed in between the third storage battery array 20-3 and the fourth storage battery array 20-4. Furthermore, in the deterioration determination device 3 for a storage battery system, in between the storage battery array block 12A and the AC/DC transfer device (PCS) 50, a current sensor 41 is installed for measuring the charging current and the discharging current between the storage battery system 11 and the AC/DC transfer device (PCS) 50.

In the deterioration determination device 3 for a storage battery system, since a single current sensor is installed in each storage battery array block 12, deterioration determination of the storage battery system 11 can be performed for each storage battery array block 12. As a result, at the time of replacing the storage batteries 10 of each storage battery array block 12, the accuracy of deterioration determination of the storage battery system 11 is enhanced using a simple structure.

### <Fourth embodiment>

Given below is the explanation of a deterioration determination device for a storage battery system according to a fourth embodiment of the present invention. In the deterioration determination device for a storage battery system according to the fourth embodiment, the main constituent elements are same as the deterioration determination device for a storage battery system according to the first to third embodiments. Hence, the identical constituent elements to the first to third embodiments are referred to by the same reference numerals. FIG. 7 is an overall configuration diagram of the deterioration determination device for a storage battery system according to the fourth embodiment of the present invention.

As illustrated in FIG. 7, in a deterioration determination device 4 for a storage battery system according to the fourth embodiment, in between the AC/DC transfer device (PCS) 50 and the current sensor 41 in the deterioration determination device 3 for a storage battery system, a switch 42 is further included for delinking the AC/DC transfer device (PCS) 50 and the storage battery system 11 at the time of stopping the charging or stopping the discharging of the storage batteries 10. Thus, by turning on or turning off the switch 42, the AC/DC transfer device (PCS) 50 and the storage battery system 11 can be electrically connected or electrically disconnected. In FIG. 7 is illustrated the state in which the AC/DC transfer device (PCS) 50 and the storage battery system 11 are electrically delinked due to the switch 42.

As a result of disposing the switch 42 between the AC/DC transfer device (PCS) 50 and the storage battery system 11, in the case of determining about the deterioration of the storage battery system 11 at the time of stopping the charging or stopping the discharging of the storage batteries 10, the AC/DC transfer device (PCS) 50 and the storage battery system 11 can be delinked from each other. Hence, the circulation current can be measured while preventing the impact caused by the AC/DC transfer device (PCS) 50. That enables achieving further enhancement in the accuracy of deterioration determination of the storage battery system 11.

Given below is the explanation of other illustrative embodiments of the deterioration determination device for a storage battery system according to the present invention. In the embodiments described above, a storage battery array includes eight storage batteries connected in series. However, depending on the conditions of use for the storage battery system, a storage battery array can include nine or more storage batteries connected in series or can include seven or less storage batteries connected in series. Moreover, in the embodiments described above, the storage battery system is divided into two storage battery array blocks. However, alternatively, the storage battery system can be divided into three storage battery array blocks or into four or more storage battery array blocks.

### <Fifth embodiment>

Given below is the explanation of a deterioration determination device for a storage battery system according to a fifth embodiment of the present invention. In the deterioration determination device for a storage battery system according to the fifth embodiment, the main constituent elements are same as the deterioration determination device for a storage battery system according to the first to fourth embodiments. Hence, the identical constituent elements to the first to fourth embodiments are referred to by the same reference numerals.

FIG. 11 is an overall configuration diagram of the deterioration determination device for a storage battery system according to the fifth embodiment of the present invention. As illustrated in FIG. 11, in a deterioration determination device 5 for a storage battery system according to the fifth embodiment, the storage battery system 11 includes a plurality of storage batteries 10. The storage batteries 10 are connected to each other in series to form storage battery arrays L11 to L14 and L21 to L24. In FIG. 11, as an example of the storage battery arrays L11 to L14 and L21 to L24, it is illustrated that four storage batteries 10 are connected to each other in series. However, the number of storage batteries 10 constituting a single storage battery array is not limited to four, and can be any number equal to or greater than two.

The storage battery arrays L11 to L14 and L21 to L24 are connected in parallel to constitute storage battery blocks B11, B12, B21, and B22. More particularly, the neighboring storage battery arrays L11 and L12 are connected to each other in parallel to constitute the storage battery array block B11; and the neighboring storage battery arrays L13 and L14 are connected to each other in parallel to constitute the storage battery array block B12. Moreover, the neighboring storage battery arrays L21 and L22 are connected to each other in parallel to constitute the storage battery array block B21; and the neighboring storage battery arrays L23 and L24 are connected to each other in parallel to constitute the storage battery array block B22. In FIG. 11, as an example of each of the storage battery blocks B11, B12, B21, and B22, it is illustrated that two storage battery arrays are connected to each other in parallel. However, the number of storage battery arrays constituting a single storage battery block is not limited two, and can also be equal to or greater than three.

The storage battery blocks B11, B12, B21, and B22 are connected in series to constitute assembled storage batteries BP1 and BP2. More particularly, the storage battery blocks B11 and B21 are connected to each other in series to constitute the assembled storage battery BP1; and the storage battery blocks B12 and B22 are connected to each other in series to constitute the assembled storage battery BP2. In FIG. 11, as an example of an assembled storage battery, it is illustrated that two storage battery blocks are connected to each other in series. However, the number of storage battery blocks constituting a single assembled storage battery is not limited two. Thus, three or more storage battery blocks can also be connected to each other in series to constitute a single assembled storage block. Moreover, in the storage battery system 11, the number of assembled storage batteries is not limited to two, and can be equal to or greater than three.

Each of the assembled storage batteries BP1 and BP2 has the current sensor 40 connected thereto in series. Moreover, the current sensor 40 connected in series to the assembled storage battery BP1 and the current sensor 40 connected in series to the assembled storage battery BP2 are connected to each other in parallel, and the connection point of the two current sensors 40 is connected to the AC/DC transfer device 50. Furthermore, the current sensor 40 connected in series to the assembled storage battery BP1 and the current sensor 40 connected in series to the assembled storage battery BP2 are also connected to the storage battery monitoring device 30.

In the storage battery system 11 illustrated in FIG. 11, when there is deterioration of any storage battery 10, the circulation current is generated at the time of stopping the charging and stopping the discharging in the storage battery system 11. The deterioration determination device 5 for a storage battery system measures the circulation current, and determines about the deterioration of the storage batteries 10 based on the measurement result.

FIG. 12 is a flowchart for explaining the flow of operations performed for determining about the deterioration of the storage batteries 10 according to the fifth embodiment. FIG. 13 is a diagram illustrating an example of the flow of the circulation current in the case in which deterioration has occurred in one of the storage batteries 10 in the assembled storage battery BP1. In FIG. 13, the deteriorating storage battery 10 is illustrated using hatching. Thus, explained below with reference to FIGS. 12 and 13 is the operation according to the fifth embodiment for determining about the deterioration occurring in the storage battery 10.

When the storage battery system 11 is operated by repeatedly performing, over a predetermined period of time, charging of the storage battery system 11 from an external electrical power system and discharging from the storage battery system 11 to the load; at the timing for determining the presence or absence of deterioration of the storage battery system 11 as set by the setting unit 31, the storage battery monitoring device 30 starts a deterioration determination operation for the storage battery system 11 as illustrated in FIG. 12.

Firstly, the storage battery monitoring device 30 refers to the information received from the current sensors 40 or the AC/DC transfer device 50, and determines whether or not the charging and the discharging of the storage battery system 11 has been stopped (Step S101). If it is determined that the charging and the discharging has not been stopped (NO at Step S101), then the storage battery monitoring device 30 again performs the operation at Step S101. When it is determined that the charging and the discharging has been stopped (YES at Step S101), the measurement control unit 32 of the storage battery monitoring device 30 obtains the circulation current flow measured by the current sensors 40 and obtains the direction of the circulation current (Step S102).

For example, as illustrated in FIG. 13, when there is deterioration of the storage battery 10 that is illustrated using hatching in the assembled storage battery BP1, a current distribution occurs in the storage battery system 11 at the time of the charging and the discharging. As a result, when the charging or the discharging is stopped, in the storage battery block B11 of the assembled storage battery BP1 in which the deteriorating storage battery 10 is present, there occurs a voltage difference between the storage battery arrays L11 and L12. In order to resolve the voltage difference, in the storage battery block B11, a circulation current i11 is generated in the direction from the storage battery array L12 to the storage battery array L11 as illustrated by an arrow in FIG. 12.

Moreover, when a circulation current is generated in the storage battery block B11, there occurs a voltage difference between the assembled storage batteries BP1 and BP2. In order to resolve the voltage difference between the assembled storage batteries BP1 and BP2, in the storage battery system 11, a circulation current is generated that flows from the assembled storage battery BP1 to the assembled storage BP2. The current sensor 40 connected to the assembled storage battery BP1 measures a circulation current i1 that flows from the assembled storage battery BP2 into the assembled storage battery BP1; and the current sensor 40 connected to the assembled storage battery BP2 measures a circulation current i2 that flows out from the assembled storage battery BP2 to the assembled storage battery BP1, that is, measures the sum of a circulation current i21 flowing out from the storage battery array L13 and a circulation current i22 flowing out from the storage battery array L14.

The measurement control unit 32 of the storage battery monitoring device 30 obtains the current value and the direction of the circulation current i1, which is measured by the current sensor 40 connected to the assembled storage battery BP1, and obtains the current value and the direction of the circulation current i2, which is measured by the current sensor 40 connected to the assembled storage battery BP2 (Step S102).

Then, based on the current value and the direction of the circulation current i1 and based on the current value and the direction of the circulation current i2, the storage battery state determining unit 33 of the storage battery monitoring device 30 determines about the determination of the storage batteries 10. More particularly, firstly, the storge battery monitoring device 30 determines whether or not the sum of the current value of the circulation current i1 and the current value of the circulation current i2 is equal to or smaller than a predetermined first threshold value (Step S103). Herein, the first threshold value is set in advance by the setting unit 31.

When there is deterioration of any storage battery 10 thereby causing circulation currents between the assembled storage batteries BP1 and BP2, the circulation currents i1 and i2 have the same value but have the opposite polarity. Hence, the sum of the circulation currents i1 and i2 becomes equal to zero, and the storage battery monitoring device 30 determines that the sum is equal to or smaller than the first threshold value (YES at Step S103). Meanwhile, if NO is the determination result at Step S103, then the system control returns to Step S101.

When the sum of the current value of the circulation current i1 and the current value of the circulation current i2 is equal to or smaller than the predetermined first threshold value, based on the absolute value of the current value of the circulation current i1 and the absolute value of the current value of the circulation current i2, the storage battery monitoring device 30 determines about the deterioration of the storage battery 10 (Step S104). More particularly, the storage battery monitoring device 30 determines whether or not the absolute value of the current value of the circulation current i1 as well as the absolute value of the current value of the circulation current i2 is equal to or greater than a predetermined second threshold value. Herein, the second threshold value is set in advance by the setting unit 31. If the absolute value of the current value of the circulation current i1 as well as the absolute value of the current value of the circulation current i2 is equal to or greater than the predetermined second threshold value (YES at Step S104), then the storage battery monitoring device 30 determines that the storage battery 10 is deteriorating (Step S105). Meanwhile, if NO is the determination result at Step S104, then the system control returns to Step S101.

According to the fifth embodiment, even if the current sensor 40 is not installed in each of the storage battery arrays L11 to L12 and L21 to L24 connected in series, it becomes possible to detect the occurrence of deterioration of the storage battery 10.

Meanwhile, in the fifth embodiment, as illustrated in FIG. 14, in between the AC/DC transfer device (PCS) 50 and the current sensor 40, the switch 42 can be further included for delinking the AC/DC transfer device (PCS) 50 and the storage battery system 11 at the time of stopping the charging or stopping the discharging of the storage batteries 10. Thus, by turning on or turning off the switch 42, the AC/DC transfer device (PCS) 50 and the storage battery system 11 can be electrically connected or electrically disconnected. In FIG. 14 is illustrated the state in which the AC/DC transfer device (PCS) 50 and the storage battery system 11 are electrically delinked due to the switch 42.

As a result of disposing the switch 42 between the AC/DC transfer device (PCS) 50 and the storage battery system 11, in the case of determining about the deterioration of the storage battery system 11 at the time of stopping the charging or stopping the discharging of the storage batteries 10, the AC/DC transfer device (PCS) 50 and the storage battery system 11 can be delinked from each other. Hence, the circulation current can be measured while preventing the impact caused by the AC/DC transfer device (PCS) 50. That enables achieving further enhancement in the accuracy of deterioration determination of the storage battery system 11. Meanwhile, the switch 42 can be a mechanical switch or a semiconductor switch.

### Industrial Applicability

The present invention can be used in determining about the deterioration of storage batteries.

### Reference Signs List

- 1, 2, 3, 4: deterioration determination device for a storage battery system
- 10: storage battery
- 11: storage battery system
- 12: storage battery array block
- 20: storage battery array
- 30: storage battery monitoring device
- 32: measurement control unit
- 33: storage battery state determining unit
- 40: current sensor
- 80: current sensor

## Claims

1. A deterioration determination device for a storage battery system in which a plurality of storage battery arrays, each of which is formed by connecting a plurality of storage batteries to each other in series, is connected to each other in parallel, wherein the storage batteries are bipolar lead storage batteries, in the storage battery arrays connected to each other, the storage batteries positioned at end portion of the storage battery arrays are connected to each other in parallel, and the storage batteries positioned in middle part of the storage battery arrays are connected to each other in parallel, because of which the storage battery system is divided into a plurality of storage battery array blocks, the deterioration determination device comprising:
a current sensor configured to, at a time of stopping charging or stopping discharging of the storage batteries, measure circulation current generated among the storage battery arrays in each of the storage battery array blocks;
a measurement control unit configured to collect a value of the circulation current measured by the current sensor; and
a storage battery state determining unit configured to, from the collected value of the circulation current, determine whether or not there is deterioration of the storage batteries in the storage battery array blocks.

2. The deterioration determination device for the storage battery system according to claim 1, wherein one of the storage battery array blocks is connected to other of the storage battery array blocks in series by a single connection.

3. The deterioration determination device for the storage battery system according to claim 1 or 2, wherein the current sensor is installed in plurality in each of the storage battery array blocks.

4. The deterioration determination device for the storage battery system according to claim 3, wherein, in each of the storage battery array blocks, the current sensor is installed between each neighboring pair of the storage battery arrays.

5. The deterioration determination device for the storage battery system according to claim 1 or 2, wherein the current sensor is installed in singularity in each of the storage battery array blocks.

6. The deterioration determination device for the storage battery system according to any one of claims 1 to 5, wherein, between an AC/DC transfer device and the storage battery system, a switch is disposed for delinking the AC/DC transfer device and the storage battery system at time of stopping charging or stopping discharging of the storage batteries.

7. A deterioration determination method for a storage battery system in which a plurality of storage battery arrays, each of which is formed by connecting a plurality of storage batteries to each other in series, is connected to each other in parallel, wherein the storage batteries are bipolar lead storage batteries, in the storage battery arrays connected to each other, the storage batteries positioned at end portion of the storage battery arrays are connected to each other in parallel, and the storage batteries positioned in middle part of the storage battery arrays are connected to each other in parallel, because of which the storage battery system is divided into a plurality of storage battery array blocks, the deterioration determination method comprising:
a step of measuring, at a time of stopping charging or stopping discharging of the storage batteries, circulation current generated among the storage battery arrays in each of the storage battery array blocks,
a step of collecting a value of the circulation current measured by the current sensor; and
a step of determining, from the collected value of the circulation current, whether or not there is deterioration of the storage batteries in the storage battery array blocks.

8. A deterioration determination device for a storage battery system including a plurality of assembled storage batteries each of which is formed by connecting, in series, a plurality of storage battery blocks in which a plurality of storage battery arrays, each of which is formed by connecting a plurality of storage batteries to each other in series, are connected to each other in parallel, wherein the storage batteries are bipolar lead storage batteries, the deterioration determination device comprising:
a measurement control unit configured to collect values of circulation currents measured by current sensors which are disposed corresponding to the assembled storage batteries, are connected to each other in parallel, and measure, at time of stopping charging or stopping discharging of the storage batteries, the circulation currents generated among the assembled storage batteries; and
a storage battery state determining unit configured to, from the collected values of the circulation currents, determine about the deterioration of the storage batteries.

9. The deterioration determination device for the storage battery system according to claim 8, wherein, when sum of the circulation currents measured by the current sensors is equal to or smaller than a predetermined first threshold value and when absolute value of each of the circulation currents measured by the current sensors is equal to or greater than a predetermined second threshold value, the storage battery state determining unit determines that there is deterioration of the storage batteries.

10. A storage battery monitoring device for monitoring a storage battery system including a plurality of assembled storage batteries each of which is formed by connecting, in series, a plurality of storage battery blocks in which a plurality of storage battery arrays, each of which is formed by connecting a plurality of storage batteries to each other in series, are connected to each other in parallel, and in which the assembled storage batteries are connected to each other in parallel, wherein the storage batteries are bipolar lead storage batteries, the storage battery monitoring device comprising:
a measurement control unit configured to collect values of circulation currents measured by current sensors which are disposed corresponding to the assembled storage batteries, are connected to each other in parallel, and measure, at time of stopping charging or stopping discharging of the storage battery, the circulation currents generated among the assembled storage batteries; and
a storage battery state determining unit configured to, from the collected values of the circulation currents, determine about the deterioration of the storage batteries.

11. The storage battery monitoring device according to claim 10, wherein, when sum of the circulation currents measured by the current sensors is equal to or smaller than a predetermined first threshold value and when absolute value of each of the circulation currents measured by the current sensors is equal to or greater than a predetermined second threshold value, the storage battery state determining unit determines that there is deterioration of the storage batteries.

12. A storage battery system comprising:
the deterioration determination device for a storage battery system according to claim 8 or 9 or the storage battery monitoring device according to claim 10 or 11; and
a storage battery array in which a plurality of storage batteries is connected to each other in series, wherein
the storage batteries are bipolar lead storage batteries,
the assembled storage batteries are connected to each other in parallel, and
in corresponding manner to the assembled storage batteries, current sensors are disposed that measure, at time of stopping charging or stopping discharging of the storage batteries, circulation currents generated among the assembled storage batteries, and are connected to each other in parallel.

13. A deterioration determination method for a storage battery system including a plurality of assembled storage batteries each of which is formed by connecting, in series, a plurality of storage battery blocks in which a plurality of storage battery arrays, each of which is formed by connecting a plurality of storage batteries to each other in series, are connected to each other in parallel, wherein the storage batteries are bipolar lead storage batteries, the deterioration determination method comprising:
a step of collecting values of circulation currents measured by current sensors which are disposed corresponding to the assembled storage batteries, are connected to each other in parallel, and measure, at time of stopping charging or stopping discharging of the storage batteries, the circulation currents generated among the assembled storage batteries; and
a step of determining, from the collected values of the circulation currents, about deterioration of the storage batteries.
